# DEMANDE DE BREVET EUROPEEN

(11) **EP 4 318 597 A1**
(43) Date de publication de la demande: **07.02.2024**
(21) Numéro de dépôt: 23188340.6
(22) Date de dépôt: 28.07.2023
(51) Int. Cl.: H01L 29/778, H01L 21/338, H01L 21/8252, H01L 27/085, H01L 27/092, H01L 29/45, H01L 29/10, H01L 29/417, H01L 29/20, H01L 27/06

(54) **TRANSISTOR À EFFET DE CHAMP AYANT UN COMPORTEMENT DE TYPE P-FET**

(30) Priorité: 01.08.2022 FR 2207976
(71) Demandeur: Commissariat à l'énergie atomique et aux énergies alternatives, 75015 Paris (FR)
(72) Inventeur: BUCKLEY, Julien, 38054 GRENOBLE CEDEX 09 (FR); ESCOFFIER, René, 38054 GRENOBLE CEDEX 09 (FR); LE ROYER, Cyrille, 38054 GRENOBLE CEDEX 09 (FR); MOHAMAD, Blend, 38054 GRENOBLE CEDEX 09 (FR)
(74) Mandataire: Cabinet Camus Lebkiri

(57) **Abrégé**

L'invention concerne un transistor à effet de champ (2) comprenant :
- un substrat (21) ;
- une couche de canal d'électrons (22) disposée sur le substrat (21) ;
- une couche barrière (23) disposée sur la couche de canal d'électrons (22) ;
- une couche de canal de trous (24) disposée sur la couche barrière (23) ;
- une couche de matériau semi-conducteur dopé de type p (25) disposée sur la couche de canal de trous (24) ;
- une électrode de source (27) comprenant une première portion (27a) en contact ohmique avec la couche de canal d'électrons (22) et une deuxième portion (27b) en contact ohmique avec la couche de matériau semi-conducteur dopé de type p (25) ;
- une électrode de drain (28) en contact ohmique avec la couche de canal d'électrons (22) ;
- une électrode de grille (29) disposée en regard de la couche de matériau semi-conducteur dopé de type p (25), entre les électrodes de source et de drain (27-28).

## Description

### DOMAINE TECHNIQUE DE L'INVENTION

Le domaine technique de l'invention est celui de l'électronique de puissance. La présente invention concerne un transistor à effet de champ (ou FET, pour « Field Effect Transistor » en anglais) à base de matériaux semi-conducteurs III-N tels que le nitrure de gallium (GaN).

### ARRIERE-PLAN TECHNOLOGIQUE DE L'INVENTION

Le transistor à haute mobilité d'électrons (ou HEMT, pour « High Electron Mobility Transistor » en anglais) est un transistor à effet de champ bénéficiant des propriétés de conduction d'un gaz d'électrons bidimensionnel (ou 2DEG, pour « 2-Dimensional Electron Gas » en anglais). Il comprend un empilement vertical de couches de semi-conducteur III-N sur un substrat, typiquement en silicium, carbure de silicium ou saphir. Le gaz d'électrons bidimensionnel est formé par une hétérojonction entre une couche de canal, typiquement en nitrure de gallium (GaN), et une couche de barrière, typiquement en nitrure d'aluminium-gallium (AIGaN).

Le transistor HEMT supporte des densités de courant élevées à l'état passant, en raison de la forte densité de porteurs de charge et de la grande mobilité de ces porteurs dans le gaz d'électrons bidimensionnel. Il peut également présenter une vitesse de commutation élevée.

Le transistor HEMT est un transistor à effet de champ à canal N, communément appelé n-FET, c'est-à-dire un transistor dont la conduction est assurée par des électrons. Pour réaliser des circuits logiques compatibles avec les applications de puissance, typiquement un inverseur, ce transistor n-FET est associé à un transistor à effet de champ à canal P, ou p-FET, autrement dit un transistor dont la conduction est assurée par des trous. Le p-FET doit présenter des performances similaires à celles du transistor n-FET, notamment en termes de courant, de tenue en tension et de vitesse de commutation.

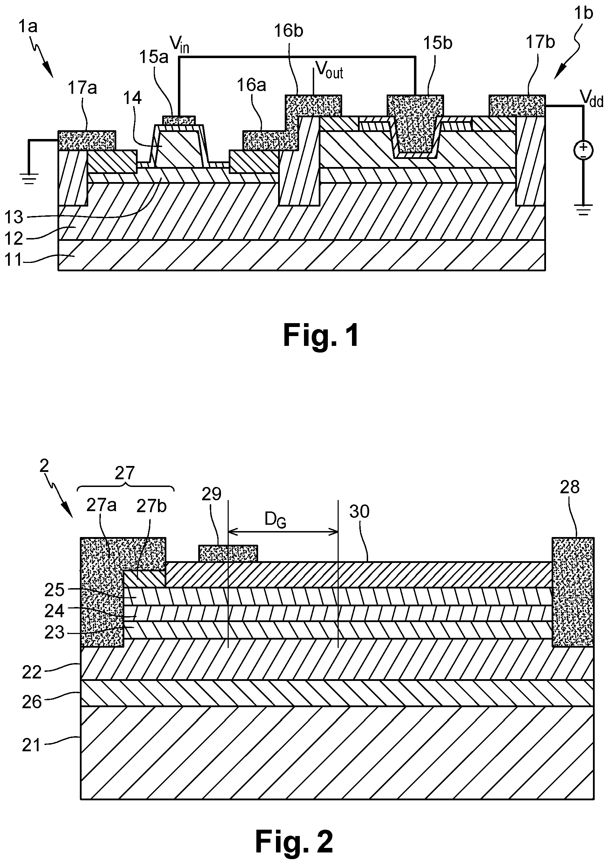

La figure 1 représente schématiquement un inverseur GaN décrit dans le document [« Gallium nitride-based complementary logic integrated circuits », Z. Zheng et al., Nature Electronics, Vol. 4, pp. 595-603, 2021]. Cet inverseur GaN comprend un transistor n-FET 1a connecté en série avec un transistor p-FET 1b.

Le transistor n-FET 1a est un transistor HEMT classique comprenant notamment un substrat 11 en silicium, une couche de canal 12 en GaN disposée sur le substrat 11, une couche barrière 13 en AlGaN disposée sur la couche de canal 12 et une structure de grille. La structure de grille comprend une couche de GaN dopée p 14 (p-GaN) et une électrode de grille 15a en contact avec la couche de p-GaN 14 (grille dite p-GaN). Le transistor n-FET 1a comprend en outre une électrode de drain 16a et une électrode de source 17a en contact ohmique avec le gaz d'électrons bidimensionnel situé au voisinage immédiat de l'interface entre la couche de canal 12 et la couche barrière 13.

Le transistor p-FET 1b comprend le même empilement de couches semi-conductrices 11 à 14, une électrode de grille 15b, une électrode de drain 16b et une électrode de source 17b. La couche de p-GaN 14 forme une couche de conduction de trous qui s'étend continûment entre l'électrode de drain 16b et l'électrode de source 17b. La portion de la couche de p-GaN 14 située sous la grille 15b constitue la région de canal et est amincie pour pouvoir être contrôlée efficacement (et électro-statiquement) par la grille 15b. Cette portion est soumise à un traitement plasma oxygène pour dépeupler la région de canal en trous (à l'équilibre thermique) et conférer au transistor p-FET un comportement normalement fermé.

En raison de la faible mobilité des trous dans la couche de p-GaN 14 (comparée à celle des électrons dans le 2DEG), la densité de courant du transistor p-FET 1b est environ 100 fois inférieure à celle du transistor n-FET 1a. Pour pouvoir supporter le même courant, le transistor p-FET 1b doit donc avoir une surface active environ 100 fois supérieure à celle du transistor n-FET 1a, ce qui augmente le coût de l'inverseur.

### RESUME DE L'INVENTION

On constate qu'il existe un besoin de prévoir un transistor à effet de champ présentant le comportement d'un transistor p-FET et une densité de courant élevée, typiquement du même ordre de grandeur que celle d'un transistor n-FET formé à partir des mêmes matériaux semi-conducteurs.

Selon un premier aspect de l'invention, on tend à satisfaire ce besoin en prévoyant un transistor à effet de champ comprenant :
- un substrat ;
- une couche de canal d'électrons disposée sur le substrat ;
- une couche barrière disposée sur la couche de canal d'électrons ;
- une couche de canal de trous disposée sur la couche barrière ;
- une couche de matériau semi-conducteur dopé de type p disposée sur la couche de canal de trous ;
- une électrode de source comprenant une première portion en contact ohmique avec la couche de canal d'électrons et une deuxième portion en contact ohmique avec la couche de matériau semi-conducteur dopé de type p ;
- une électrode de drain en contact ohmique avec la couche de canal d'électrons ;
- une électrode de grille disposée en regard de la couche de matériau semi-conducteur dopé de type p, entre les électrodes de source et de drain.

Le contact ohmique entre la deuxième portion de l'électrode de source et la couche de matériau semi-conducteur dopé de type p permet l'injection de trous libres dans la couche de canal de trous lorsqu'une tension négative est appliquée entre l'électrode de grille et l'électrode de source. Ces trous attirent des électrons libres à l'interface entre la couche de canal d'électrons et la couche barrière, formant ainsi un canal de conduction entre l'électrode de source et l'électrode de drain. Le transistor à effet de champ se comporte alors comme un transistor p-FET alors que sa conduction est assurée par des électrons.

Dans un premier mode de réalisation du transistor, la couche de matériau semi-conducteur dopé de type p s'étend de façon continue de l'électrode de source jusqu'à l'électrode de drain et l'électrode de drain est en contact Schottky avec la couche de matériau semi-conducteur dopé de type p.

Dans un deuxième mode de réalisation, la couche de matériau semi-conducteur dopé de type p s'étend de façon discontinue de l'électrode de source jusqu'à l'électrode de drain et l'électrode de drain est en contact ohmique avec la couche de matériau semi-conducteur dopé de type p.

Outre les caractéristiques qui viennent d'être évoquées dans les paragraphes précédents, le transistor selon le premier aspect de l'invention peut présenter une ou plusieurs caractéristiques complémentaires parmi les suivantes, considérées individuellement ou selon toutes les combinaisons techniquement possibles :
- la couche de canal de trous est en un matériau semi-conducteur non intentionnellement dopé ;
- la couche de canal d'électrons et la couche de canal de trous sont formées d'un même matériau, par exemple du nitrure de gallium non intentionnellement dopé ;
- la couche de matériau semi-conducteur dopé de type p est une couche de nitrure de gallium dopé de type p ;
- la couche de canal d'électrons est constituée de nitrure de gallium non intentionnellement dopé et la couche barrière est constituée de nitrure d'aluminium-galium, de préférence non intentionnellement dopé ;
- l'électrode de grille est séparée de la couche de matériau semi-conducteur dopé de type p par une couche diélectrique ;
- la couche de matériau semi-conducteur dopé de type p présente une concentration en impuretés dopantes comprise entre 1.10¹⁷ cm⁻³ et 1.10¹⁸ cm⁻³ ;
- la couche barrière est constituée de nitrure d'aluminium-galium et présente une taux d'aluminium compris entre 15 % et 25 % ; et
- la couche barrière est constituée de nitrure d'aluminium-galium et présente une épaisseur comprise entre 2 nm et 10 nm.

Un deuxième aspect de l'invention concerne un circuit intégré comprenant :
- un substrat ;
- une couche de canal d'électrons disposée sur le substrat ;
- une couche barrière disposée sur la couche de canal d'électrons ;
- une couche de canal de trous disposée sur la couche barrière ;
- une couche de matériau semi-conducteur dopé de type p disposée sur la couche de canal de trous ;
- une première électrode de source comprenant une première portion en contact ohmique avec la couche de canal d'électrons et une deuxième portion en contact ohmique avec la couche de matériau semi-conducteur dopé de type p ;
- une première électrode de drain en contact ohmique avec la couche de canal d'électrons ;
- une première électrode de grille disposée en regard de la couche de matériau semi-conducteur dopé de type p, entre les électrodes de source et de drain ;
- une deuxième électrode de source en contact ohmique avec la couche de canal d'électrons ;
- une deuxième électrode de drain en contact ohmique avec la couche de canal d'électrons ; et
- une structure de grille disposée entre les deuxièmes électrodes de source et de drain ;
les premières électrodes de source, de drain et de grille appartenant à un transistor à effet de champ selon le premier aspect de l'invention et la deuxième électrode de source, la deuxième électrode de drain et la structure de grille appartenant à un transistor à haute mobilité d'électrons.

La première électrode de drain peut être reliée électriquement à la deuxième électrode de drain de sorte à être soumise au même potentiel électrique.

Dans un mode de réalisation préférentiel, la structure de grille du transistor à haute mobilité d'électrons comprend une portion de la couche de matériau semi-conducteur dopé de type p et une deuxième électrode de grille disposée en regard de ladite portion.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1, précédemment décrite, est une vue en coupe d'un inverseur GaN selon l'art antérieur ;
- la figure 2 représente schématiquement un premier mode de réalisation d'un transistor à effet de champ selon le premier aspect de l'invention ;
- la figure 3 représente schématiquement le transistor à effet de champ de la figure 2 à l'état bloqué ;
- la figure 4 représente schématiquement le transistor à effet de champ de la figure 2 à l'état passant ;
- la figure 5 montre des caractéristiques I_{DS}-V_{GS} d'un exemple de transistor selon la figure 2, ces caractéristiques correspondant à différentes concentrations de dopants dans une couche de GaN dopé p ;
- la figure 6 montre des caractéristiques I_{DS}-V_{GS} d'un exemple de transistor selon la figure 2, ces caractéristiques correspondant à différentes pourcentages d'aluminium dans une couche barrière en AlGaN ;
- la figure 7 montre des caractéristiques I_{DS}-V_{GS} d'un exemple de transistor selon la figure 2, ces caractéristiques correspondant à différentes épaisseurs d'une couche barrière en AlGaN ;
- la figure 8 montre des caractéristiques I_{DS}-V_{DS} d'un exemple de transistor selon la figure 2, ces caractéristiques correspondant à différentes tensions de grille V_{GS} ;
- la figure 9 montre des caractéristiques I_{DS}-V_{GS} d'un exemple de transistor selon la figure 2, ces caractéristiques correspondant à différentes positions de l'électrode de grille ;
- la figure 10 représente schématiquement un deuxième mode de réalisation du transistor à effet de champ selon le premier aspect de l'invention ;
- les figures 11A à 11E représentent des étapes d'un procédé de fabrication du transistor à effet de champ selon la figure 2 ;
- la figure 12 représente schématiquement un mode de réalisation préférentiel d'un circuit intégré selon le deuxième aspect de l'invention ; et
- la figure 13 représente schématiquement une variante de réalisation du circuit intégré selon le deuxième aspect de l'invention.

Pour plus de clarté, les éléments identiques ou similaires sont repérés par des signes de référence identiques sur l'ensemble des figures.

### DESCRIPTION DETAILLEE

La figure 2 est une vue en coupe schématique d'un transistor à effet de champ 2 selon un premier mode de réalisation. Le transistor à effet de champ 2 est un composant électronique formé à partir de matériaux semi-conducteur III-N. Il trouve des applications avantageuses en électronique de puissance.

Le transistor 2 est assimilable à un transistor (de type) p-FET dans la mesure où il présente une tension de seuil V_{T} négative et un courant drain-source I_{DS} négatif. Toutefois, contrairement au transistor p-FET de l'art antérieur (dont la conduction à l'état passant est assurée par des trous), le courant du transistor 2 (à l'état passant) est dû au transport d'électrons. Le transistor 2 est donc un transistor à courant d'électrons ayant un comportement de type p-FET (on le nommera plus simplement ci-après transistor p-FET à courant d'électrons). Connecté à un ou plusieurs transistors n-FET, il peut former des portes logiques, par exemple un inverseur.

En référence à la figure 2, le transistor 2 comprend un substrat 21 et un empilement vertical de couches semi-conductrices sur le substrat 21. Cet empilement comprend au moins :
- une couche de canal d'électrons 22 disposée sur le substrat 21 ;
- une couche barrière 23 disposée sur la couche de canal d'électrons 22 ;
- une couche de canal de trous 24 disposée sur la couche barrière 23 ; et
- une couche de matériau semi-conducteur dopé de type p 25, disposée sur la couche de canal de trous 24 et appelée ci-après couche dopée p.

Le substrat 21 est par exemple en silicium (Si), en carbure de silicium (SiC), en nitrure de galium (GaN) ou en saphir (Al₂O₃). La couche de canal d'électrons 22, la couche barrière 23, la couche de canal de trous 24 et la couche dopée p 25 sont des couches semi-conductrices en matériau semi-conducteur III-V, de préférence à base de nitrure de galium (GaN) (autrement dit en GaN ou en un alliage de GaN comme AIGaN, InGaN... ).

La couche de canal d'électrons 22 est la couche dans laquelle se forme le canal de conduction du transistor 2. Elle est constituée d'un premier matériau semi-conducteur III-N. La couche barrière 23 est constituée d'un deuxième matériau semi-conducteur III-N présentant une largeur de bande interdite supérieure à celle du premier matériau semi-conducteur III-N (couche de canal d'électrons 22), afin de créer une barrière de potentiel.

La discontinuité de la bande de conduction à l'interface entre la couche de canal d'électrons 22 et la couche barrière 23 forme sous certaines conditions de polarisation un puits de potentiel dans lequel les électrons sont confinés, créant ainsi un gaz bidimensionnel d'électrons (ou 2DEG, pour « 2-Dimensional Electron Gaz » en anglais).

Ainsi, le transistor 2 comprend une première hétérostructure comprenant la couche de canal d'électrons 22 et la couche barrière 23. La première hétérostructure est par exemple de type GaN/AIGaN. La couche de canal d'électrons 22 est alors constituée de nitrure de galium, de préférence non intentionnellement dopé (UID GaN), tandis que la couche barrière 23 est constituée de nitrure d'aluminium-galium, de préférence non intentionnellement dopé (UID AIGaN). Un matériau semi-conducteur est considéré comme non intentionnellement dopé lorsque ses concentrations en dopants de type donneur et de type accepteur sont inférieures à 10¹⁶ cm⁻³ (N_{A}<10¹⁶ cm⁻³ et N_{D}<10¹⁶ cm⁻³). De préférence, la couche de canal d'électrons 22 présente une épaisseur comprise entre 20 nm et 500 nm, tandis que la couche barrière 23 présente une épaisseur comprise entre 2 nm et 30 nm. L'épaisseur d'une couche est mesurée dans une direction perpendiculaire au substrat 21.

La première hétérostructure peut également comprendre une couche intermédiaire (non illustrée sur la figure), disposée entre la couche de canal d'électrons 22 et la couche barrière 23, pour accroître la densité et la mobilité des électrons dans le gaz d'électrons bidimensionnel. Une telle couche intermédiaire, aussi appelée couche espaceur, est typiquement extrêmement fine (épaisseur inférieure ou égale à 1 nm) et peut être constituée de nitrure d'aluminium (AIN), ce matériau étant particulièrement adapté à l'interface entre une couche de canal d'électrons 22 en GaN et une couche barrière 23 en AIGaN.

La couche de canal des trous 24 est constituée d'un troisième matériau semi-conducteur III-N présentant une largeur de bande interdite inférieur de celle du deuxième matériau semi-conducteur III-N (couche barrière 23). Le troisième matériau semi-conducteur III-N (couche de canal des trous 24) est de préférence non intentionnellement dopé. Il est avantageusement identique au premier matériau semi-conducteur III-N (couche de canal d'électrons 22), par exemple du GaN non intentionnellement dopé. De préférence, la couche de canal des trous 24 présente une épaisseur comprise entre 5 nm et 300 nm.

Ainsi, le transistor 2 comprend une deuxième hétérostructure comprenant la couche barrière 23 et la couche de canal des trous 24. La deuxième hétérostructure est juxtaposée à la première hétérostructure (on parle aussi de double hétérostructure, ici GaN/AlGaN/GaN).

La couche dopée p 25 est de préférence constituée d'un quatrième matériau semi-conducteur III-N dopé p. La couche dopée p 25 est par exemple une couche de GaN dopé p (ou p-GaN). Elle présente une concentration en impuretés dopantes de type p qui est avantageusement comprise entre 1.10¹⁶ cm⁻³ et 5.10¹⁸ cm⁻³. L'épaisseur de la couche dopée p 25 peut être comprise entre 5 nm et 40 nm. Les impuretés dopantes de la couche dopée p 25 sont par exemple des ions magnésium. La couche de canal de trous 24 et la couche dopée p 25 sont de préférence accolées, c'est-à-dire disposées en contact direct.

La couche dopée p 25 est distincte de la couche de canal des trous 24, dans le sens où elle présente un dopage différent de la couche de canal des trous 24 (dopage p versus non intentionnellement dopé).

Toujours en référence à la figure 2, le transistor 2 comprend avantageusement une couche tampon 26, semi-isolante, disposée entre le substrat 21 et la couche de canal d'électrons 22. Cette couche tampon 26 limite les courants de fuite latéraux et verticaux dans le transistor 2 et améliore sa tenue en tension (latérale) dans l'état bloqué. La couche tampon 26 comprend de préférence un matériau semi-conducteur III-N, tel que le GaN ou l'AIGaN. Ce matériau semi-conducteur peut être dopé avec des impuretés, telles que des atomes de carbone. La couche tampon 26 peut notamment être formée par une seule couche de GaN:C ou par un bicouche GaN:C/AlₓGa₁₋ₓN, avec x compris entre 4 % et 8 % environ. L'épaisseur de la couche tampon 26 est par exemple comprise entre 1 µm et 15 µm.

Outre l'empilement de couches semi-conductrices, le transistor 2 comprend une électrode de source 27, une électrode de drain 28 et une électrode de grille 29. Il peut également comprend une couche diélectrique 30 qui recouvre l'empilement de couches semi-conductrices, et plus particulièrement la couche dopée p 25, entre l'électrode de source 27 et l'électrode de drain 28.

L'électrode de source 27 comprend une première portion 27a en contact ohmique avec la couche de canal d'électrons 22 et une deuxième portion 27b en contact ohmique avec la couche dopée p 25. Les première et deuxième portions 27a-27b de l'électrode de source 27 sont agencées de manière à être soumises au même potentiel électrique. Elles sont de préférence accolées (autrement dit en contact direct).

La première portion 27a peut s'étendre verticalement (c'est-à-dire perpendiculairement au substrat 21) jusqu'à la couche de canal d'électrons 22, comme cela est représenté sur la figure 2, jusqu'à l'intérieur de la couche barrière 23 ou jusqu'à la face supérieure de la couche barrière 23. Elle est constituée d'un matériau métallique ou de plusieurs matériaux métalliques empilés. La première portion 27a de l'électrode de source 27 est par exemple constituée d'un empilement bicouche comprenant une couche d'aluminium disposée sur une couche de titane (le titane étant en contact avec la couche de canal d'électrons 22 ou la couche barrière 23, selon la profondeur du contact ohmique).

La deuxième portion 27b de l'électrode de source 27 peut être également constituée d'un matériau métallique ou de plusieurs matériaux métalliques empilés. Ces matériaux sont avantageusement différents de ceux de la première portion 27a. La deuxième portion 27b est par exemple constituée d'un empilement bicouche du type nickel/or (le nickel étant en contact avec la couche dopée p 25) recuit par exemple sous N₂ :O₂ à 560 °C durant 40 min. Alternativement, la deuxième portion 27b peut être formée d'un empilement bicouche comprenant une couche métallique, par exemple en magnésium, disposée sur une couche de matériau semi-conducteur III-N fortement dopé p (p⁺⁺ ; concentration comprise entre 10¹⁸ cm⁻³ et 10²⁰ cm⁻³) afin de former un contact (ohmique) faiblement résistif avec la couche dopée p 25.

L'électrode de drain 28 est en contact ohmique avec la couche de canal d'électrons 22. Elle est avantageusement formée du même matériau métallique ou du même empilement de matériaux métalliques que la première portion 27a de l'électrode de source 27.

L'électrode de grille 29 est disposée en regard de la couche dopée p 25 entre l'électrode de source 27 et l'électrode de drain 28. Elle est de préférence séparée de la couche dopée p 25 par la couche diélectrique 30, comme cela est représentée par la figure 2. Alternativement, l'électrode de grille 29 peut être en contact Schottky avec la couche dopée p 25. L'électrode de grille 29 peut être constituée d'un matériau métallique ou de plusieurs matériaux métalliques empilés. Elle est par exemple formée de nitrure de titane (TiN).

La couche diélectrique 30 sert de couche de passivation en neutralisant les défauts à la surface de la couche dopée p 25. Elle peut être constituée d'un seul matériau électriquement isolant, par exemple de dioxyde de silicium (SiO₂), nitrure de silicium (Si₃N₄), nitrure d'aluminium (AIN) ou alumine (Al₂O₃). Alternativement, la couche de passivation peut comporter plusieurs sous-couches empilées et formées de matériaux isolants différents, typiquement une alternance de sous-couche en oxyde (ex. SiO₂) et en nitrure (ex. SiN).

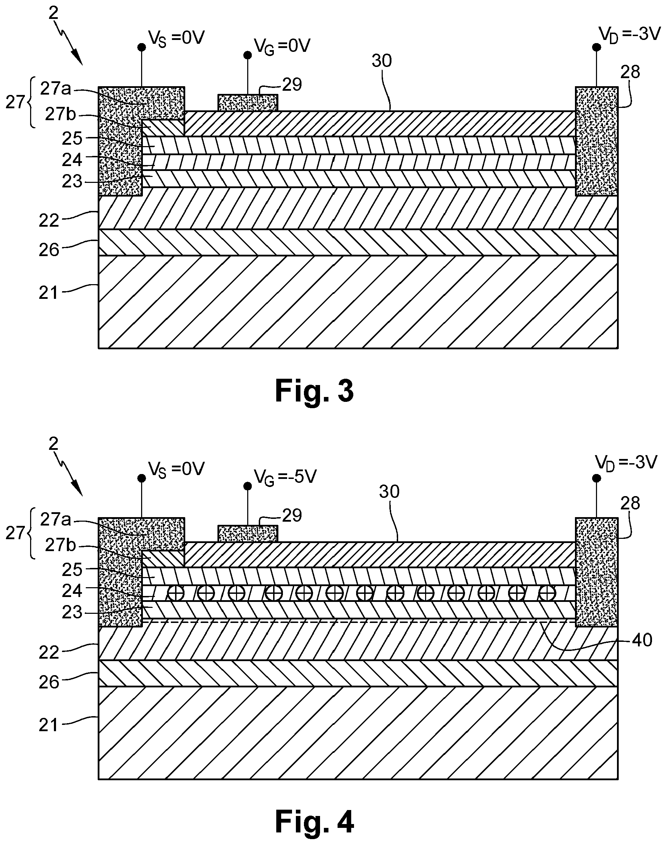

Le fonctionnement du transistor 2 va maintenant être décrit en relation avec les figures 3 et 4. Les potentiels électriques de l'électrode de source 27, de l'électrode de drain 28 et de l'électrode de grille 29 sont notés respectivement Vs, V_{D} et V_{G}.

Lorsque la tension grille-source V_{GS} est nulle, par exemple lorsque V_{G} = Vs = 0 V (cf. Fig.3), la couche dopée p 25 déplète le gaz d'électrons bidimensionnel situé dans la couche de canal d'électrons 22 au voisinage immédiat de l'interface entre la couche de canal d'électrons 22 et la couche barrière 23 (comme dans un transistor HEMT à grille p-GaN). Aucun courant (d'électrons) ne circuit de l'électrode de drain 28 vers l'électrode de source 27 lorsqu'une tension drain-source V_{DS} négative (par exemple V_{D} = -3 V) est appliquée. Le transistor 2 est à l'état bloqué.

En revanche, lorsqu'une tension grille-source V_{GS} fortement négative est appliquée, par exemple en choisissant V_{G} = -5 V et Vs = 0 V (cf. Fig.4), des trous libres sont injectés dans la couche de canal de trous 24 par l'électrode de source 27 à travers la couche dopée p 25, grâce au contact ohmique entre la deuxième portion 27b de l'électrode de source 27 et la couche dopée p 25. Ces trous se répartissent dans la couche de canal de trous 24 de l'électrode de source 27 jusqu'à l'électrode de drain 28, du fait du champ électrique généré par la tension drain-source V_{DS} négative (par exemple V_{D} = -3 V). Ils attirent par effet électrostatique des électrons libres à l'interface entre la couche de canal d'électrons 22 et la couche barrière 23, reconstituant ainsi un canal de conduction 40 qui relient électriquement l'électrode de source 27 et l'électrode de drain 28. Sur la figure 4, le canal de conduction 40 est symbolisé par des traits en pointillés dans la couche de canal d'électrons 22 le long de l'interface entre la couche de canal d'électrons 22 et la couche barrière 23. Un courant d'électrons circule dans ce canal 40 (de l'électrode de drain 28 vers l'électrode de source 27) sous l'effet du champ électrique généré par la tension drain-source V_{DS} négative. Le transistor 2 est à l'état passant.

Ainsi, le transistor 2 se comporte comme un transistor p-FET (tension de seuil V_{T} négative et courant I_{DS} négatif sous une tension drain-source V_{DS} négative) de type normalement fermé (aucun courant sous une tension de grille V_{GS} nulle).

Contrairement au gaz d'électrons bidimensionnel qui se forme par hétérojonction entre la couche de canal d'électrons 22 et la couche barrière 23 (en l'absence de la couche dopée p 25), le canal de conduction 40 ne présente pas une concentration en électrons uniforme. Cela est dû à une répartition non uniforme des trous dans la couche de canal de trous 24 et du champ électrique du fait de la polarisation de la grille 29.

La mobilité des électrons dans le canal de conduction 40 est néanmoins bien supérieure à la mobilité des trous dans une couche de canal en p-GaN. Le transistor 2 présente donc une densité de courant bien plus élevée que le transistor p-FET de l'art antérieur. La densité de courant à l'état passant du transistor 2 est du même ordre de grandeur que celle d'un transistor à haute mobilité d'électrons (HEMT), étant donné que la conduction dans ces deux types de transistor repose sur le même type de porteurs de charge.

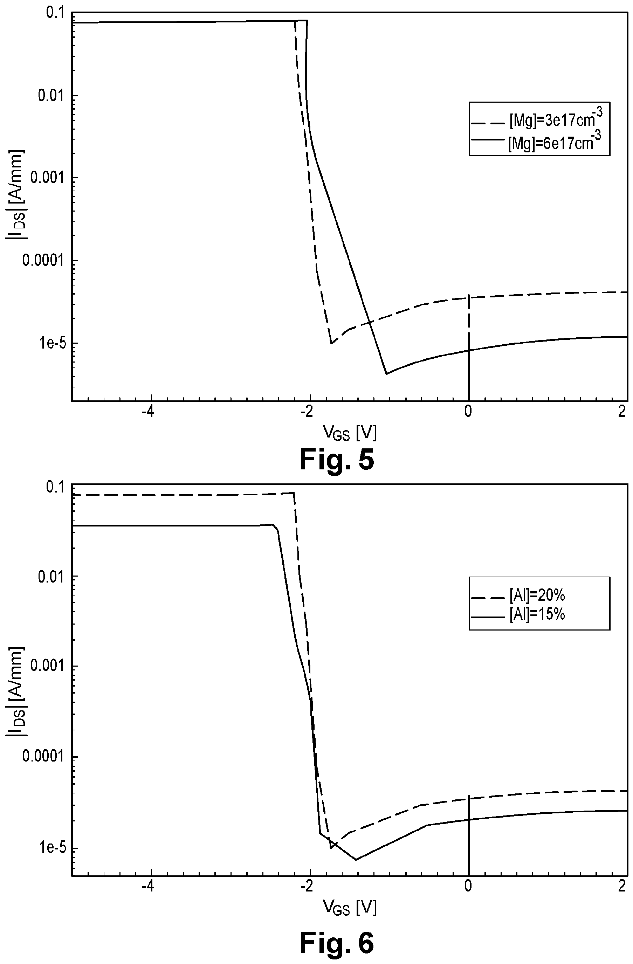

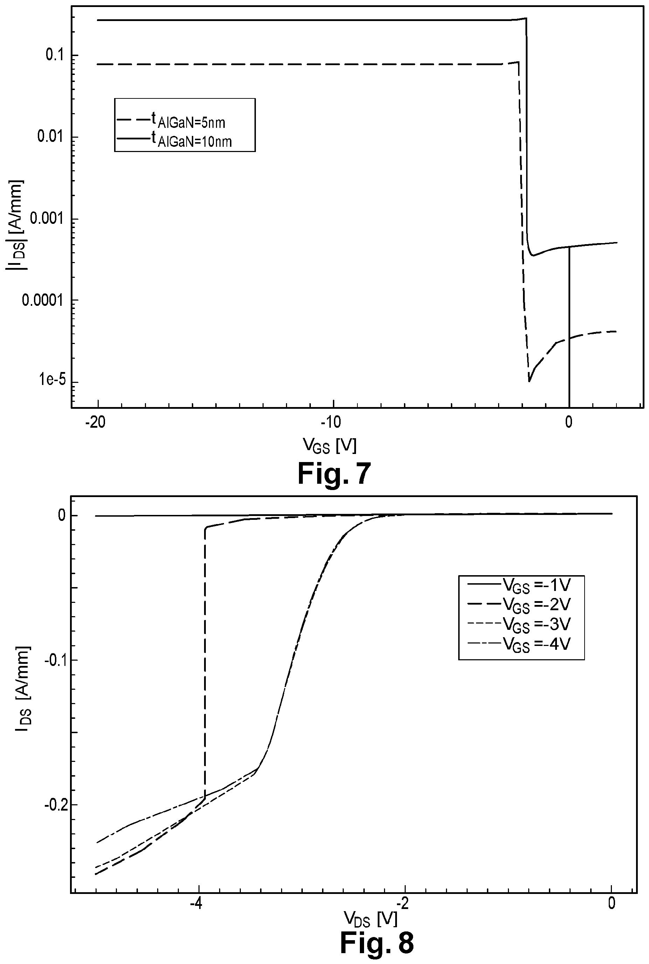

Les figures 5 à 9 représentent différentes caractéristiques courant-tension d'un exemple de transistor selon la figure 2. Ces caractéristiques ont été obtenues par des simulations électriques TCAD. Dans cet exemple, le transistor 2 comprend une couche de canal d'électrons 22 en GaN UID de 3 µm d'épaisseur, une couche barrière 23 en AlGaN UID, une couche de canal de trous 24 en GaN UID de 10 nm d'épaisseur et une couche dopée p 25 en p-GaN de 5 nm d'épaisseur. La concentration en impuretés dopantes (ions magnésium) dans la couche dopée p 25 est égale à 3.10¹⁷ cm⁻³, sauf dans la simulation de la figure 5 où ce paramètre varie. Le taux d'aluminium dans la couche barrière 23 en AlGaN est égal à 20 %, sauf dans la simulation de la figure 6 où ce paramètre varie. L'épaisseur de la couche barrière 23 en AlGaN est égal à 5 nm, sauf dans la simulation de la figure 7 où ce paramètre varie.

La figure 5 représente (en échelle logarithmique) le courant drain-source I_{DS} en valeur absolue (noté |I_{DS}|) en fonction de la tension grille-source V_{GS}, pour plusieurs valeurs de la concentration en impuretés dopantes (ions magnésium) dans la couche dopée p 25. Cette figure montre que le taux de dopage de la couche dopée p 25 influe sur le courant à l'état bloqué (le courant de fuite). Plus la concentration en impuretés dopantes est élevée, plus le courant à l'état bloqué est faible. Cela s'explique par une plus forte déplétion du gaz d'électrons bidimensionnel. En revanche, le taux de dopage n'influe pas sur le courant à l'état passant, car les trous libres injectés dans la couche de canal de trous 24 ne proviennent pas de la couche dopée p 25. Une concentration en impuretés dopantes comprise entre 1.10¹⁷ cm⁻³ et 1.10¹⁸ cm⁻³ constitue un bon compromis entre courant de fuite et tension de seuil.

On peut également noter que, dans cet exemple, la tension de seuil V_{T} du transistor est d'environ -2 V et que la densité de courant à l'état passant est de l'ordre de 0,1 A/mm.

La figure 6 représente le courant drain-source |I_{DS}| (toujours en échelle logarithmique) en fonction de la tension grille-source V_{GS}, pour plusieurs valeurs du taux d'aluminium dans la couche barrière 23 en AIGaN. Cette figure montre que le courant à l'état passant du transistor augmente avec le taux d'aluminium dans la couche barrière 23. En effet, plus le taux d'aluminium est important, plus le niveau de polarisation positive dans la couche barrière 23 à l'interface avec la couche de canal d'électrons 22 est élevé et donc plus le canal de conduction 40 est riche en électrons. Le courant de fuite augmente également, car le gaz d'électrons bidimensionnel est moins déplété à l'état bloqué. Un taux d'aluminium compris entre 15 % et 25 % constitue un bon compromis entre courant à l'état passant et courant à l'état bloqué.

La figure 7 représente le courant drain-source |I_{DS}| (toujours en échelle logarithmique) en fonction de la tension grille-source V_{GS}, pour plusieurs valeurs d'épaisseur de la couche barrière 23 en AlGaN (notée t_{AlGaN}). Cette figure montre que le courant à l'état passant et le courant à l'état bloqué du transistor augmente avec l'épaisseur de la couche barrière 23, car elle induit une variation de son champ électrique lié aux charges de polarisation. Une épaisseur comprise entre 2 nm et 10 nm constitue un bon compromis entre courant à l'état passant et courant à l'état bloqué.

La figure 8 représente le courant drain-source I_{DS} (en échelle linéaire) en fonction de la tension drain-source V_{DS}, pour plusieurs valeurs de la tension grille-source V_{GS}. Cette figure montre un effet de seuil dans l'augmentation du courant drain-source |I_{DS}| (I_{DS} en valeur absolue) lorsque la tension drain-source |V_{DS}| augmente. Cet effet de seuil est caractéristique de la diode Schottky formée par la deuxième portion 27b de l'électrode de source 27, la couche dopée p 25 et l'électrode de drain 28.

Autrement dit, il faut dépasser une valeur seuil de tension drain-source |V_{DS}| pour pouvoir injecter les trous dans la couche de canal de trous 24 et créer (par effet électrostatique) le canal de conduction 40.

La figure 8 montre également que cette valeur seuil de tension drain-source |V_{DS}| diminue lorsque la tension grille-source |V_{GS}| augmente, jusqu'à environ |V_{GS}| = 3 V (V_{GS} = -3 V).

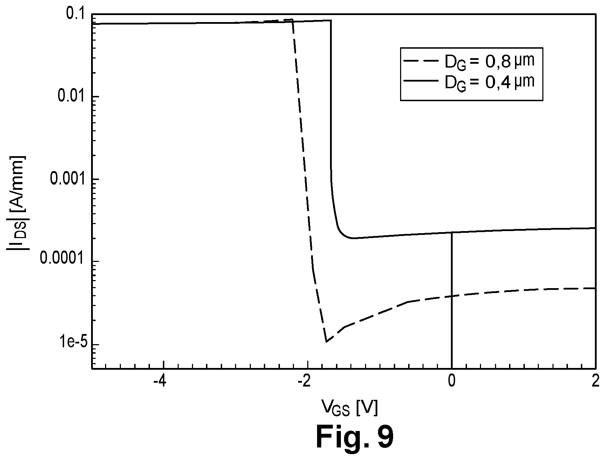

La figure 9 représente le courant drain-source |I_{DS}| (toujours en échelle logarithmique) en fonction de la tension grille-source V_{GS}, pour plusieurs valeurs de la position D_{G} de l'électrode de grille 29. La position D_{G} de l'électrode de grille 29 est la distance qui sépare le centre de l'électrode de grille 29 du centre des couches 23 à 25 (cf. Fig.2). La position D_{G} de la grille modifie la répartition du champ électrique dans la structure et influe sur la tension de seuil V_{T} ainsi que le courant à l'état bloqué. Une position D_{G} comprise entre 0,4 µm et 0,8 µm constitue un bon compromis entre courant à l'état bloqué et tension de seuil.

Dans le premier mode de réalisation illustré par la figure 2, la couche dopée p 25 s'étend de façon continue de l'électrode de source 27 jusqu'à l'électrode de drain 28. Le gaz d'électrons bidimensionnel est alors totalement déplété, ce qui minimise le courant de fuite du transistor 2 dans l'état bloqué. L'électrode de drain 28 est en contact Schottky avec la couche dopée p 25, afin d'éviter un courant de trous dans la couche dopée p 25.

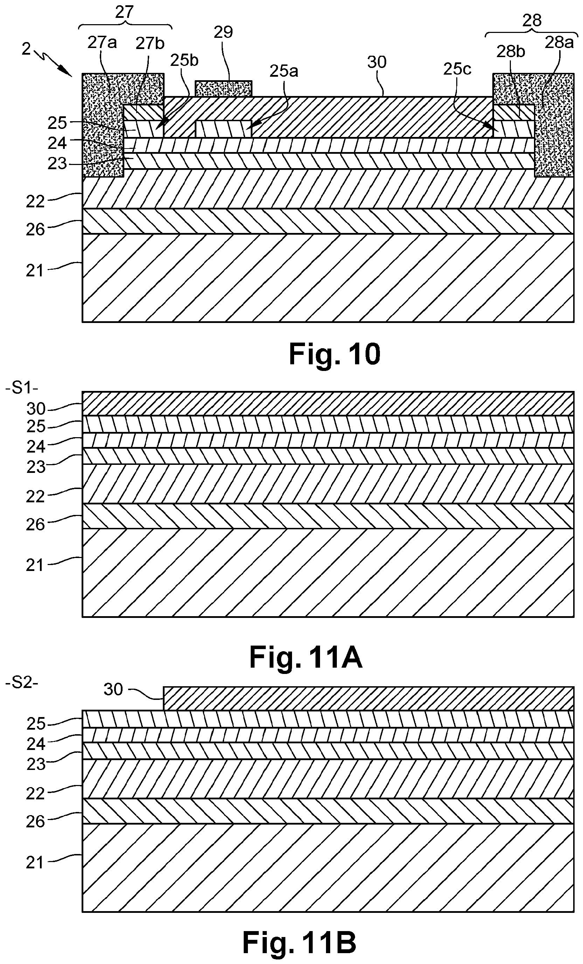

La figure 10 représente un deuxième mode de réalisation du transistor p-FET à courant d'électrons 2. Ce deuxième mode de réalisation diffère du premier mode de réalisation (Fig.2) en ce que la couche dopée p 25 s'étend de façon discontinue de l'électrode de source 27 jusqu'à l'électrode de drain 28. Plus particulièrement, la couche dopée p 25 comprend plusieurs portions disjointes, une première portion 25a située en regard, ou autrement dit à l'aplomb, de l'électrode de grille 29, une deuxième portion 25b située en contact ohmique avec la deuxième portion 27b de l'électrode de source 27 et une troisième portion 25c en contact ohmique avec l'électrode de drain 28.

Les contacts ohmiques (entre l'électrode de source 27 et la couche dopée p 25 d'une part et entre l'électrode de drain 28 et la couche dopée p 25 d'autre part) permettent de générer à l'état passant un courant de trous dans la couche de canal de trous 24, qui s'additionne au courant d'électrons dans le canal de conduction 40. Le transistor 2 selon ce deuxième mode de réalisation bénéficie donc d'une densité de courant légèrement plus élevée que le transistor 2 selon le premier mode de réalisation (le courant de trous est largement inférieur au courant d'électrons, en raison de la plus faible mobilité des trous).

L'électrode de drain 28 peut ainsi comporter, à l'instar de l'électrode de source 27, une première portion 28a en contact ohmique avec la couche de canal d'électrons 22 et une deuxième portion 28b en contact ohmique avec la couche dopée p 25. La première portion 27a de l'électron de source 27 et la première portion 28a de l'électron de drain 28 sont de préférence formées du ou des mêmes matériaux métalliques. La deuxième portion 27b de l'électron de source 27 et la deuxième portion 28b de l'électron de drain 28 sont de préférence formées du ou des mêmes matériaux (métallique et/ou semi-conducteur III-V fortement dopé).

Un exemple de procédé de fabrication du transistor p-FET à courant d'électrons 2 va maintenant être décrit en relation avec les figures 11A-11E. Ces figures représentent schématiquement des étapes S1 à S5 pour fabriquer le transistor 2 de la figure 2.

L'étape S1 illustrée par la figure 11A comprend la formation de l'empilement de couches semi-conductrices sur le substrat 21. L'empilement est de préférence formé à partir du substrat 21 en faisant croître successivement par épitaxie la couche tampon 26 (si nécessaire), la couche de canal d'électrons 22, la couche barrière 23, la couche de canal de trous 24 et la couche dopée p 25.

L'étape S1 peut comprendre en outre le dépôt de la couche diélectrique 30, ou couche de passivation, sur la couche dopée p 25. La couche de passivation 30 recouvre de préférence toute la face supérieure de la couche dopée p 25. Le dépôt de la couche de passivation 30 et la croissance des couches semi-conductrices sont de préférence des opérations accomplies dans le même équipement.

L'étape S2 de la figure 11B consiste à graver une portion de la couche de passivation 30 de manière à pouvoir accéder à la couche dopée p 25 et former ultérieurement la deuxième portion 27b de l'électrode de source 27. Autrement dit, une portion de la couche dopée p 25 est découverte. Cette première étape de gravure S2, appelée étape d'ouverture du contact ohmique sur la couche dopée p 25, est sélective par rapport à la couche dopée p 25.

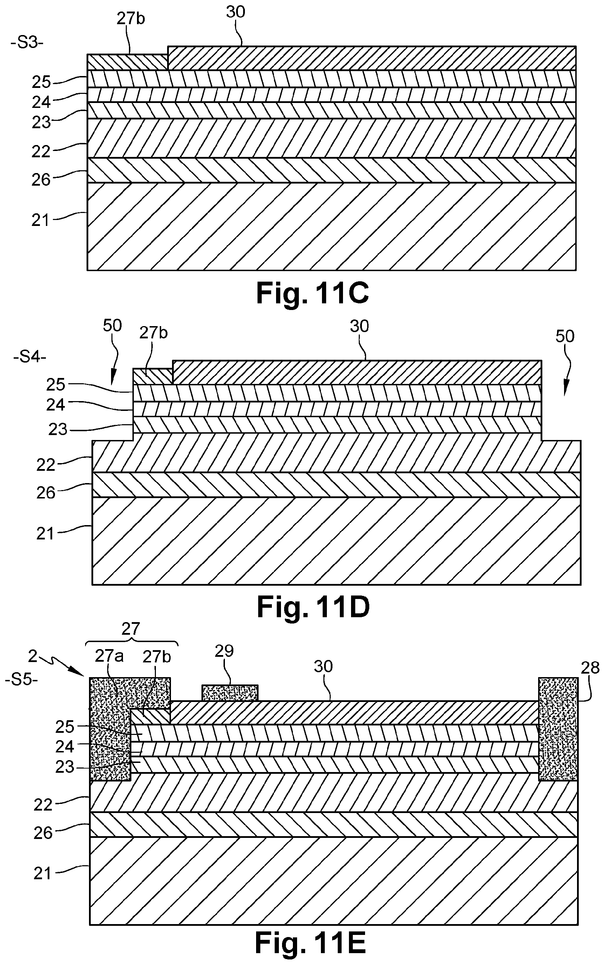

L'étape S3 de la figure 11C consiste à former la deuxième portion 27b de l'électrode de source 27, en contact ohmique avec la couche dopée p 25. Pour mémoire, la deuxième portion 27b peut comprendre une couche dite de contact en un matériau semi-conducteur III-N fortement dopée p (p⁺⁺) ou une couche de matériau métallique, en contact direct avec la couche dopée p 25.

Dans un premier mode de mise en oeuvre de cette étape S3, la formation de la deuxième portion 27b comprend le dépôt d'une première couche métallique sur la portion découverte de la couche dopée p 25 et sur la couche de passivation 30, puis la gravure de la portion de la première couche métallique disposée sur la couche de passivation 30. La première couche métallique peut comprendre plusieurs sous-couches empilées et formées de matériaux métalliques différents (par exemple en Ni/Au).

Dans un deuxième mode de mise en oeuvre, la formation de la deuxième portion 27b comprend la croissance (par épitaxie) d'une couche de contact dopée p⁺⁺ uniquement sur la portion découverte de la couche dopée p 25 (la couche de passivation 30 empêchant la croissance par ailleurs).

Dans une variante de mise en oeuvre du procédé de fabrication, la croissance (par épitaxie) de la couche de contact dopée p⁺⁺ est accomplie à l'étape S1 de formation de l'empilement de couches semi-conductrices, après la croissance de la couche dopée p 25 et avant le dépôt de la couche de passivation 30. La couche de contact dopée p⁺⁺ recouvre alors entièrement la couche dopée p 25. Elle est ensuite gravée pour délimiter la deuxième portion 27b de l'électrode de source 27. Puis, la couche de passivation 30 est formée sur la couche dopée p 25, à l'endroit où la couche de contact dopée p⁺⁺ a été gravée.

En référence à la figure 11D, le procédé de fabrication comprend ensuite une étape S4 au cours de laquelle deux cavités 50 destinées à la réalisation des électrodes de drain et de source sont gravées dans l'empilement de couches. Cette étape S4 est appelée étape d'ouverture des contacts source et drain. La gravure peut s'étendre jusqu'à la face supérieure de la couche barrière 23 (donc à travers la couche de passivation 30 ou la couche de contact dopée p⁺⁺, la couche dopée p 25 et la couche de canal de trous 24), jusqu'à l'intérieur de la couche barrière 23 (la couche barrière 23 est en outre gravée sur une partie de son épaisseur) ou, comme cela est représenté par la figure 11D, jusqu'à l'intérieur de la couche de canal d'électrons 22 (la couche barrière 23 est gravée sur toute son épaisseur et la couche de canal d'électrons 22 est gravée sur une partie de son épaisseur).

Enfin, l'étape S5 de la figure 11E consiste à former la première portion 27a de l'électrode de source 27 et l'électrode de drain 28 dans les cavités 50, ainsi que l'électrode de grille 29 sur la couche de passivation 30, en regard de la couche dopée p 25. La première portion 27a de l'électrode de source 27 est formée de manière à être en contact avec la deuxième portion 27b.

Avantageusement, la première portion 27a de l'électrode de source 27 et l'électrode de drain 28 sont formées simultanément, par dépôt et gravure d'une deuxième couche métallique. A l'instar de la première couche métallique, la deuxième couche métallique peut comprendre plusieurs sous-couches empilées et formées de matériaux métalliques différents. La deuxième couche métallique est de préférence déposée sur toute la surface du substrat (« dépôt pleine plaque »), autrement dit au fond et contre les parois latérales des cavités 50, sur la deuxième portion 27b de l'électrode de source 27 et sur la couche de passivation 30. Puis, la portion de la deuxième couche métallique disposée sur la couche de passivation 30 est gravée (sélectivement par rapport à la couche de passivation 30).

L'électrode de grille 29 peut être également formée par dépôt et gravure d'une troisième couche métallique (ladite troisième couche métallique pouvant comprendre plusieurs sous-couches), avant ou après la première portion 27a de l'électrode de source 27 et l'électrode de drain 28.

Pour fabriquer le transistor 2 de la figure 10, l'étape S1 de formation de l'empilement peut comprend en outre une opération de gravure de la couche dopée p 25, sélectivement par rapport à la couche de canal de trous 24. Cette opération de gravure est de préférence accomplie avant l'opération de dépôt de la couche de passivation 30, de sorte que celle-ci recouvre également la partie découverte de la couche de canal de trous 24. En raison de cette étape de gravure sélective, le transistor 2 de la figure 10 est plus difficile à réaliser que le transistor 2 de la figure 2.

La structure du transistor p-FET à courant d'électrons 2 est remarquable en ce qu'elle est très proche de celle d'un transistor HEMT classique, et plus particulièrement d'un transistor HEMT à grille p-GaN. Il devient donc facile d'intégrer sur un même substrat un transistor p-FET à courant d'électrons 2 et un transistor n-FET de type HEMT.

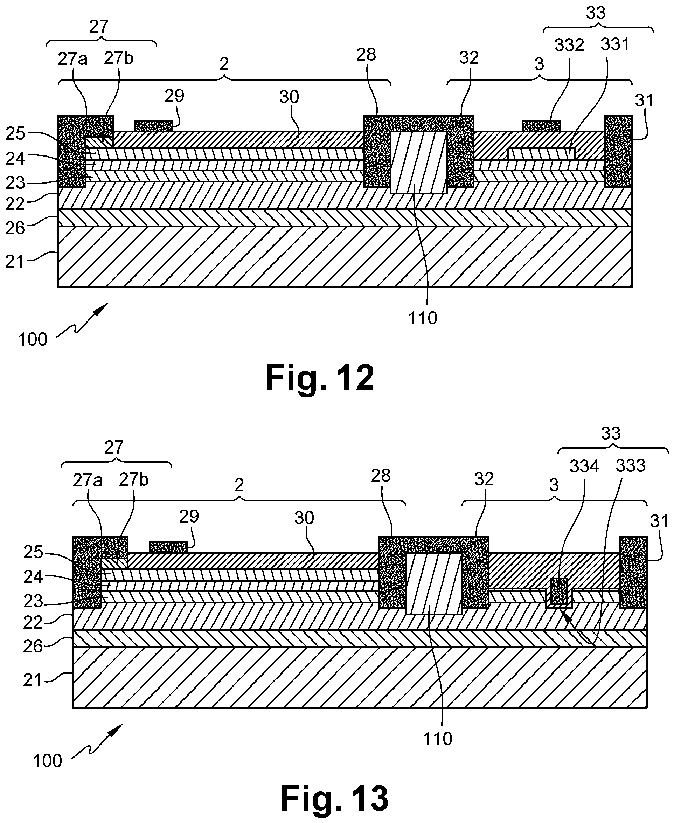

La figure 12 représente un mode de réalisation préférentiel d'un circuit intégré 100 comprenant un transistor p-FET à courant d'électrons 2 et un transistor HEMT 3.

Ce circuit intégré 100 comprend le substrat 21 et l'empilement de couches semi-conductrices décrits précédemment en relation avec la figure 2. Une première partie de l'empilement est dédiée à la formation du transistor p-FET à courant d'électrons 2 et une deuxième partie de l'empilement est dédiée à la formation du transistor HEMT 3. Une tranchée d'isolation électrique 110 isole électriquement la partie de l'empilement dédiée au transistor p-FET à courant d'électrons 2 et celle dédiée au transistor HEMT 3. La tranchée d'isolation électrique 110 s'étend au moins à travers la couche dopée p 25, la couche de canal de trous 24, la couche barrière 23 et une partie de la couche de canal d'électrons 22 (de façon à isoler électriquement le canal de conduction 40 du transistor p-FET 2 et le 2DEG du transistor HEMT 3).

Outre la deuxième partie de l'empilement, le transistor HEMT 3 comprend :
- une électrode de source 31 en contact ohmique avec la couche de canal d'électrons 22 ;
- une électrode de drain 32 en contact ohmique avec la couche de canal d'électrons 22 ; et
- une structure de grille 33 disposée entre les électrodes de source et de drain 31-32.

L'électrode de drain 28 du transistor p-FET 2 peut être reliée électriquement à l'électrode de drain 32 du transistor HEMT 3 de sorte à être soumise au même potentiel électrique. Les deux transistors sont alors connectés en série, formant la base d'un inverseur.

Dans ce mode de réalisation préférentiel, la structure de grille 33 du transistor HEMT 3 comprend une portion 331 de la couche dopée p 25, par exemple en p-GaN, et une électrode de grille 332 disposée en regard de ladite portion 331. Ainsi, la structure de grille 33 est une structure de grille de type p-GaN.

La portion 331 de la couche dopée p 25 est séparée de l'électrode de source 31 et de l'électrode de drain 32 du transistor HEMT 3 par une portion de la couche de passivation 30. L'électrode de grille 332 peut être séparée de la portion 331 de la couche dopée p 25 par la couche de passivation 30, comme cela est illustré par la figure 12, ou au contraire être accolée à ladite portion 331.

Dans une variante de réalisation du circuit intégré 100 illustrée par la figure 13, le transistor HEMT 3 comprend une structure de grille 33 de type MOS, c'est-à-dire une structure de grille 33 comprenant une couche diélectrique de grille 333 (par exemple formée du même matériau diélectrique que la couche de passivation 30) et une électrode de grille 334 (typiquement en métal). L'électrode de grille 334 est séparée de la couche de canal d'électrons 22 et de la couche barrière 23 par la couche diélectrique de grille 333. La structure de grille 33 est dite enterrée, car dans cette variante de réalisation, elle s'étend à travers la couche barrière 23 jusqu'à la couche de canal d'électrons 22 (pour « couper » le 2DEG en deux). La couche dopée p 25 et une partie au moins de la couche de canal de trous 24 ont été avantageusement retirées dans la deuxième partie de l'empilement dédiée au transistors HEMT 3. Le transistor p-FET à courant d'électrons 2 est identique à celui représenté par les figures 2 et 12.

Naturellement, tous ces modes de réalisation du circuit intégré 100 sont compatibles avec le transistor p-FET à courant d'électrons 2 illustré par la figure 10. L'opération de gravure sélective de la couche dopée p 25 est alors avantageusement accomplie pour les deux transistors simultanément.

## Revendications

1. Transistor à effet de champ (2) comprenant :
- un substrat (21) ;
- une couche de canal d'électrons (22) disposée sur le substrat (21) ;
- une couche barrière (23) disposée sur la couche de canal d'électrons (22) ;
- une couche de canal de trous (24) disposée sur la couche barrière (23) ;
- une couche de matériau semi-conducteur dopé de type p (25) disposée sur la couche de canal de trous (24) ;
- une électrode de source (27) comprenant une première portion (27a) en contact ohmique avec la couche de canal d'électrons (22) et une deuxième portion (27b) en contact ohmique avec la couche de matériau semi-conducteur dopé de type p (25) ;
- une électrode de drain (28) en contact ohmique avec la couche de canal d'électrons (22) ;
- une électrode de grille (29) disposée en regard de la couche de matériau semi-conducteur dopé de type p (25), entre les électrodes de source et de drain (27-28).

2. Transistor (2) selon la revendication 1, dans lequel la couche de matériau semi-conducteur dopé de type p (25) s'étend de façon continue de l'électrode de source (27) jusqu'à l'électrode de drain (28) et dans lequel l'électrode de drain (28) est en contact Schottky avec la couche de matériau semi-conducteur dopé de type p (25).

3. Transistor (2) selon la revendication 1, dans lequel la couche de matériau semi-conducteur dopé de type p (25) s'étend de façon discontinue de l'électrode de source (27) jusqu'à l'électrode de drain (28) et dans lequel l'électrode de drain (28) est en contact ohmique avec la couche de matériau semi-conducteur dopé de type p (25).

4. Transistor (2) selon l'une quelconque des revendications 1 à 3, dans lequel la couche de canal d'électrons (22) et la couche de canal de trous (24) sont formées d'un même matériau, par exemple du nitrure de gallium non intentionnellement dopé.

5. Transistor (2) selon l'une quelconque des revendications 1 à 4, dans lequel la couche de matériau semi-conducteur dopé de type p (25) est une couche de nitrure de gallium dopé de type p.

6. Transistor (2) selon l'une quelconque des revendications 1 à 5, dans lequel la couche de canal d'électrons (22) est constituée de nitrure de gallium non intentionnellement dopé et dans lequel la couche barrière (23) est constituée de nitrure d'aluminium-galium, de préférence non intentionnellement dopé.

7. Transistor (2) selon l'une quelconque des revendications 1 à 6, dans lequel l'électrode de grille (29) est séparée de la couche de matériau semi-conducteur dopé de type p (25) par une couche diélectrique (30).

8. Transistor selon l'une quelconque des revendications 1 à 7, dans lequel la couche de matériau semi-conducteur dopé de type p (25) présente une concentration en impuretés dopantes comprise entre 1.10¹⁷ cm⁻³ et 1.10¹⁸ cm-.

9. Transistor selon l'une quelconque des revendications 1 à 8, dans lequel la couche barrière (23) est constituée de nitrure d'aluminium-galium et présente une taux d'aluminium compris entre 15 % et 25 %.

10. Transistor selon l'une quelconque des revendications 1 à 9, dans lequel la couche barrière (23) est constituée de nitrure d'aluminium-galium et présente une épaisseur (t_{AlGaN}) comprise entre 2 nm et 10 nm.

11. Circuit intégré (100) comprenant :
- un substrat (21) ;
- une couche de canal d'électrons (22) disposée sur le substrat (21) ;
- une couche barrière (23) disposée sur la couche de canal d'électrons (22) ;
- une couche de canal de trous (24) disposée sur la couche barrière (23) ;
- une couche de matériau semi-conducteur dopé de type p (25) disposée sur la couche de canal de trous (24) ;
- une première électrode de source (27) comprenant une première portion (27a) en contact ohmique avec la couche de canal d'électrons (22) et une deuxième portion (27b) en contact ohmique avec la couche de matériau semi-conducteur dopé de type p (25) ;
- une première électrode de drain (28) en contact ohmique avec la couche de canal d'électrons (22) ;
- une première électrode de grille (29) disposée en regard de la couche de matériau semi-conducteur dopé de type p (25), entre les électrodes de source et de drain (27-28) ;
- une deuxième électrode de source (31) en contact ohmique avec la couche de canal d'électrons (22) ;
- une deuxième électrode de drain (32) en contact ohmique avec la couche de canal d'électrons (22) ; et
- une structure de grille (33) disposée entre les deuxièmes électrodes de source et de drain ;
circuit dans lequel les premières électrodes de source (27), de drain (28) et de grille (29), appartiennent à un transistor à effet de champ (2) selon l'une quelconque des revendications 1 à 10 et dans lequel la deuxième électrode de source (31), la deuxième électrode de drain (32) et la structure de grille (33) appartiennent à un transistor à haute mobilité d'électrons (3).

12. Circuit intégré (100) selon la revendication 11, dans lequel la première électrode de drain (28) est reliée électriquement à la deuxième électrode de drain (32) de sorte à être soumise au même potentiel électrique.

13. Circuit intégré (100) selon l'une des revendications 11 et 12, dans lequel la structure de grille (33) du transistor à haute mobilité d'électrons (3) comprend une portion (331) de la couche de matériau semi-conducteur dopé de type p (25) et une deuxième électrode de grille (332) disposée en regard de ladite portion (331).
